# EUROPEAN PATENT APPLICATION

(11) **EP 2 775 535 A1**
(43) Date of publication of application: **10.09.2014**
(21) Application number: 12846635.6
(22) Date of filing: 02.11.2012
(51) Int. Cl.: H01L 31/042, B32B 27/30, C09D 7/12, C09D 175/04

(54) **BACKSHEET FOR SOLAR CELL MODULE, LAMINATE, AND SOLAR CELL MODULE**

(30) Priority: 04.11.2011 JP 2011242521; 02.12.2011 JP 2011264861; 02.12.2011 JP 2011264862; 15.12.2011 JP 2011274918; 19.03.2012 JP 2012062607
(71) Applicant: Daikin Industries, Ltd., Osaka-shi, Osaka 530-8323 (JP)
(72) Inventor: NAKAGAWA Hideto, Osaka-shi Osaka 530-8323 (JP); ASANO Kazuya, Osaka-shi Osaka 530-8323 (JP); GOBOU Kenji, Osaka-shi Osaka 530-8323 (JP); OZAKI Hidenori, Osaka-shi Osaka 530-8323 (JP); SAGISAKA Shigehito, Osaka-shi Osaka 530-8323 (JP)
(74) Representative: Goddar, Heinz J.
(86) International application number: PCT/JP2012/078540
(87) International publication number: WO 2013/065854

(57) **Abstract**

An object of the present invention is to provide a backsheet, laminate, and solar cell module that can prevent the infiltration of water through a region of adhesion with the junction box. The present invention is a backsheet for a solar cell module, the backsheet having a water-impermeable sheet and a coating film formed on at least one side of the water-impermeable sheet, wherein the coating film is formed from a coating material containing a curable functional group-containing fluorinated polymer; a first surface treatment layer is formed on the coating film at least on a surface on an opposite side to the water-impermeable sheet; and the wetting index of the first surface treatment layer is at least 40 dyn/cm.

## Description

### TECHNICAL FIELD

The present invention relates to a backsheet for solar cell modules and to a laminate and a solar cell module.

### BACKGROUND ART

A solar cell module typically contains a surface layer, a sealant layer that seals a solar cell, a backsheet, and a junction box for taking off power output from a solar cell. A copolymer of ethylene and vinyl acetate (also referred to herebelow as EVA) is typically used as the sealant that forms the sealant layer.

A variety of properties, such as mechanical strength, weathering resistance, waterproofness and moistureproofness, electrical insulation, and so forth, are required of the backsheet. Backsheets typically have a multilayer structure and, for example, may contain - considered in sequence from the side in contact with the sealant layer of the solar cell - a back layer located on the sealant side of the solar cell/a water-impermeable sheet/a weathering-resistant layer positioned on the outermost side.

A resin sheet as represented by a film of polyvinyl fluoride is generally used for this weathering-resistant layer and back layer because polyvinyl fluoride exhibits an excellent weathering resistance, waterproofness and moistureproofness, and electrical insulation behavior, while a PET film is generally used for the water-impermeable sheet. In those instances where a high waterproofing/moistureproofing effect is required of the backsheet, a PET film bearing a vapor-deposited metal compound, e.g., silica, or a metal layer, e.g., an aluminum foil, is provided at the surface of the water-impermeable sheet.

In order to satisfy various required properties, i.e., properties as represented by durability, light-blocking ability, and so forth, a backsheet typically has a thickness of 20 to 500 µm. However, there has been demanded in recent years for a reduction in backsheet weight and thickness.

As a consequence, the formation of the same layers using resin coating materials in place of resin sheets has been proposed. For example, the use of an epoxy resin coating material as a resin coating material has been investigated (refer, for example, to Patent Literature 1). However, epoxy resin coating materials have not been realized at a practical level because their cured coating films have an unsatisfactory weathering resistance.

In addition, a two-layer backsheet has been proposed in which a metal substrate (a water-impermeable sheet) is coated with a PVdF-based coating material provided by the incorporation of a specific amount of a tetraalkoxysilane or its partial hydrolyzate into functional group-free PVdF (refer, for example, to Patent Literature 2). Considering this PVdF-based coating material, PVdF, because it lacks functional groups, by itself also has a poor adhesiveness for the EVA used as the sealant. Patent Literature 2 seeks to improve upon this point through the incorporation of a specific amount of a tetraalkoxysilane or partial hydrolyzate thereof and inducing the orientation of the tetraalkoxysilane or partial hydrolyzate thereof at the interface with the EVA.

A solar cell module backsheet has also been proposed in which a cured coating film from a curable functional group-containing fluorinated polymer coating material is formed on at least one side of a water-impermeable sheet (refer, for example, to Patent Literature 3). A curable tetrafluoroethylene (TFE)-based copolymer (Zeffle GK570) is disclosed as the curable functional group-containing fluorinated polymer. Patent Literature 3 teaches that, through the use of this curable functional group-containing fluorinated polymer coating material, the thickness of the backsheet can be reduced in comparison to the conventional application of a sheet and a reduction in thickness and weight can thus be devised while maintaining the mechanical strength, and that, due to the introduction of a functional group into the fluorinated polymer, the adhesiveness to the water-impermeable sheet can be improved even without the addition of, for example, a tetraalkoxysilane.

A solar cell module backsheet has also been proposed in which a cured coating film layer is formed, on one side or both sides of a substrate sheet, from a coating material that contains a fluorinated polymer (A) that has a repeat unit based on (a) a fluoroolefin, a repeat unit based on (b) a crosslinking group-containing monomer, and a repeat unit based on (c) an alkyl group-containing monomer in which a polymerizable unsaturated group is connected by an ether bond or ester bond to a C₂₋₂₀ straight-chain or branched alkyl group that does not contain the quaternary carbon atom (refer, for example, to Patent Literature 4). Patent Literature 4 teaches that such a cured coating film layer has a particularly good flexibility and a particularly good adherence to the substrate and is free of the problems of cracks, breakage, whitening, and debonding and that a lightweight, high-productivity solar cell module backsheet is obtained.

### CITATION LIST

### - Patent Literature

Patent Literature 1: JP-A H07-176775
Patent Literature 2: JP-A 2004-214342
Patent Literature 3: WO 2007/010706
Patent Literature 4: WO 2009/157449

### SUMMARY OF INVENTION

### - Technical Problem

As noted above, while various investigations have been carried out on solar cell module backsheets, there is still room for investigation in order to realize even higher levels for the various required properties'.

For example, the electrodes and wiring for taking off power output from the solar cell are typically disposed to penetrate the backsheet and connect to a terminal housed within the junction box. Since solar cells are subjected to long-term use outdoors, the electrodes and wiring must be reliably and securely protected against the infiltration of, e.g., rain water, which is a cause of corrosion. Thus, the adhesion region between the junction box and the backsheet in particular must have a high weather resistance (particularly with regard to the ability to prevent the infiltration of water).

The present invention was accomplished considering the existing circumstances as described above and has as its object the introduction of a backsheet, laminate, and solar cell module that can prevent the infiltration of water through the adhesion region with the junction box.

### - Solution to Problem

The present inventor carried out various investigations into backsheets for solar cell modules, and in the course thereof discovered that the infiltration of water through the adhesion region with the junction box could be prevented by a backsheet in which a coating film formed from a coating material containing a curable functional group-containing fluorinated polymer is formed on at least one side of the water-impermeable sheet and in which a surface treatment layer having a particular wetting index is formed on this coating film at least on the surface on the opposite side to the water-impermeable sheet. The junction box is generally bonded to the backsheet through an adhesion layer formed from, for example, a silicone resin. The present inventor discovered that, when the wetting index of the backsheet surface that will engage in bonding with the junction box is within a prescribed range, the infiltration of, e.g., rain water, from between this adhesion layer and the backsheet is impeded and corrosion of the electrodes and wiring can then be effectively prevented. It came to be understood that the problem cited above could thereby be elegantly solved and the present invention was achieved on this basis.

That is, the present invention is a backsheet for a solar cell module, having a water-impermeable sheet and a coating film formed on at least one side of the water-impermeable sheet, wherein this coating film is formed from a coating material that contains a curable functional group-containing fluorinated polymer; a first surface treatment layer is formed on this coating film at least on a surface on an opposite side to the water-impermeable sheet; and the wetting index of the first surface treatment layer is at least 40 dyn/cm.

The present invention is also a laminate that contains the backsheet described hereinabove, an adhesion layer, and a junction box, wherein the adhesion layer is disposed on the first surface treatment layer of the backsheet and the junction box is disposed on the side of the adhesion layer the surface on the opposite side to the backsheet.

The present invention is also a solar cell module that has the laminate described above and a sealant layer that seals a solar cell and is disposed on the opposite side of the backsheet to the junction box.

The present invention is described in detail in the following.

The solar cell module backsheet of the present invention (also referred to herebelow simply as the backsheet of the present invention) has a water-impermeable sheet and a coating film (also referred to herebelow as the coating film for the present invention) formed on at least one side of this water-impermeable sheet.

This coating film is formed from a coating material (also referred to herebelow as the coating material for the present invention) that contains a curable functional group-containing fluorinated polymer.

The individual components in the coating material for the present invention will be described.

The abovementioned curable functional group-containing fluorinated polymer can be exemplified by a polymer provided by the introduction of a curable functional group into a fluorinated polymer. This fluorinated polymer encompasses resinous polymers that have a distinct melting point, elastomeric polymers that exhibit rubbery elasticity, and thermoplastic elastomeric polymers intermediate between these two.

The functional group that imparts curability to the fluorinated polymer can be exemplified by the hydroxyl group (but excluding the hydroxyl group present in the carboxyl group; this also applies hereafter), the carboxyl group, the group represented by -COOCO-, the cyano group, the amino group, the glycidyl group, the silyl group, the silanate group, and the isocyanate group, and is selected as appropriate in conformity with the ease of production of the polymer and the curing system. Among the preceding, at least one group selected from the group consisting of the hydroxyl group, the carboxyl group, the group represented by -COOCO-, the cyano group, the amino group, and the silyl group is preferred for the excellent curing reactivity thereby provided, while at least one group selected from the group consisting of the hydroxyl group, the carboxyl group, the amino group, and the silyl group is more preferred. At least one group selected from the group consisting of the hydroxyl group and the carboxyl group is even more preferred in particular for the excellent reactivity and ease of polymer acquisition thereby provided. These curable functional groups are generally introduced into the fluorinated polymer by copolymerization between a fluorine-containing monomer and a curable functional group-containing monomer.

The curable functional group-containing monomer can be exemplified by hydroxyl group-containing monomers, carboxyl group-containing monomers, acid anhydride monomers, amino group-containing monomers, and silicone-based vinyl monomers, and a single one of these may be used or two or more may be used.

The curable functional group-containing fluorinated polymer under consideration preferably contains a polymerization unit based on a fluorine-containing monomer and a polymerization unit based on at least one curable functional group-containing monomer selected from the group consisting of hydroxyl group-containing monomers, carboxyl group-containing monomers, acid anhydride monomers, amino group-containing monomers, and silicone-based vinyl monomers. This curable functional group-containing fluorinated polymer more preferably contains a polymerization unit based on a fluorine-containing monomer and a polymerization unit based on at least one curable functional group-containing monomer selected from the group consisting of hydroxyl group-containing monomers and carboxyl group-containing monomers.

The polymerization unit based on curable functional group-containing monomer is preferably 1 to 20 mol% with respect to the total polymerization units in the curable functional group-containing fluorinated polymer. A more preferred lower limit is 2 mol% and a more preferred upper limit is 10 mol%.

The curable functional group-containing monomer can be exemplified by the following, but is not limited only to these examples. A single one of these may be used or two or more may be used.

### (1-1) The hydroxyl group-containing monomer:

The hydroxyl group-containing monomer can be exemplified by hydroxyl group-containing vinyl ethers, e.g., 2-hydroxyethyl vinyl ether, 3-hydroxypropyl vinyl ether, 2-hydroxypropyl vinyl ether, 2-hydroxy-2-methylpropyl vinyl ether, 4-hydroxybutyl vinyl ether, 4-hydroxy-2-methylbutyl vinyl ether, 5-hydroxypentyl vinyl ether, and 6-hydroxyhexyl vinyl ether, and by hydroxyl group-containing allyl ethers such as 2-hydroxyethyl allyl ether, 4-hydroxybutyl allyl ether, and glycerol monoallyl ether. The hydroxyl group-containing vinyl ethers, and particularly 4-hydroxybutyl vinyl ether and 2-hydroxyethyl vinyl ether, are preferred among the preceding for their excellent polymerization reactivity and excellent functional group curability.

The hydroxyalkyl esters of (meth)acrylic acid, e.g., 2-hydroxyethyl acrylate and 2-hydroxyethyl methacrylate, are examples of other hydroxyl group-containing monomers.

The carboxyl group-containing monomers given below are not encompassed by the hydroxyl group-containing monomers cited above.

### (1-2) The carboxyl group-containing monomer:

The carboxyl group-containing monomer can be exemplified by unsaturated carboxylic acids represented by general formula (1) 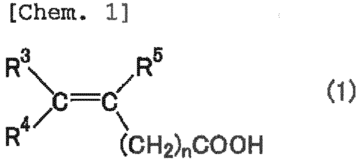 (in the formula, R³, R⁴, and R⁵ are each independently the hydrogen atom, an alkyl group, an aryl group, the carboxyl group, or an alkoxycarbonyl group, and n is 0 or 1), e.g., unsaturated monocarboxylic acids, unsaturated dicarboxylic acids and their monoesters, and so forth, and can also be exemplified by carboxyl group-containing vinyl ether monomers represented by general formula (2) 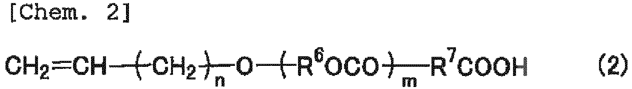 (in the formula, R⁶ and R⁷ are each independently a saturated or unsaturated, straight-chain or cyclic alkyl group, n is 0 or 1, and m is 0 or 1).

The unsaturated carboxylic acids represented by general formula (1) can be specifically exemplified by acrylic acid, methacrylic acid, vinylacetic acid, crotonic acid, cinnamic acid, itaconic acid, monoesters of itaconic acid, maleic acid, maleate monoesters, fumaric acid, and fumarate monoesters. Among the preceding, low-homopolymerizable crotonic acid, itaconic acid, maleic acid, maleate monoesters, fumaric acid, and fumarate monoesters are preferred because they have a low homopolymerizable and thus are resistant to the formation of homopolymers.

The carboxyl group-containing vinyl ether monomer represented by general formula (2) can be specifically exemplified by one or two or more selections from 3-allyloxypropionic acid, 3-(2-allyloxyethoxycarbonyl)propionic acid, 3-(2-allyloxybutoxycarbonyl)propionic acid, 3-(2-vinyloxyethoxycarbonyl)propionic acid, 3-(2-vinyloxybutoxycarbonyl)propionic acid, and so forth. Among the preceding, 3-(2-allyloxyethoxycarbonyl)propionic acid and so forth offer the advantages of good monomer stability and good polymerization reactivity and thus are preferred.

In addition to the carboxyl group-containing monomers represented by general formulas (1) and (2), the alkenyl esters of polybasic carboxylic acids, e.g., vinyl phthalate and vinyl pyromellitate, can be used as the carboxyl group-containing monomer.

### (1-3) The acid anhydride monomer:

The acid anhydride monomer can be exemplified by the anhydrides of unsaturated dicarboxylic acids, e.g., maleic anhydride and so forth.

### (1-4) The amino group-containing monomer:

The amino group-containing monomer can be exemplified by amino vinyl ethers represented by CH₂=CH-O-(CH₂)ₓ-NH₂ (x = 0 to 10), amines represented by CH₂=CH-O-CO(CH₂)ₓ-NH₂ (x = 1 to 10), and also aminomethylstyrene, vinylamine, acrylamide, vinylacetamide, and vinylformamide.

### (1-5) The silicone-based vinyl monomer:

The silicone-based vinyl monomer can be exemplified by (meth)acrylate esters such as CH₂=CHCO₂ (CH₂)₃Si (OCH₃)₃, CH₂=CHCO₂(CH₂)₃Si (OC₂H₅)₃, CH₂=C(CH₃)CO₂(CH₂)₃Si(OCH₃)₃, CH₂=C(CH₃)CO₂(CH₂)₃Si(OC₂H₅)₃, CH₂=CHCO₂(CH₂)₃SiCH₃(OC₂H₅)₂, CH₂=C(CH₃)CO₂(CH₂)₃SiC₂H₅(OCH₃)₂, CH₂=C(CH₃)CO₂(CH₂)₃Si(CH₃)₂(OC₂H₅), CH₂=C (CH₃)CO₂(CH₂)₃Si(CH₃)₂OH, CH₂=CH(CH₂)₃Si(OCOCH₃)₃, CH₂=C(CH₃)CO₂(CH₂)₃SiC₂H₅(OCOCH₃)₂, CH₂=C(CH₃)CO₂(CH₂)₃SiCH₃(N (CH₃)COCH₃)₂, CH₂=CHCO₂(CH₂)₃SiCH₃[ON(CH₃)C₂H₅]₂, and CH₂=C(CH₃)CO₂(CH₂)₃SiC₆H₅[ON(CH₃)C₂H₅]₂; vinylsilanes such as CH₂=CHSi[ON=C(CH₃)(C₂H₅)]₃, CH₂=CHSi(OCH₃)₃, CH₂=CHSi(OC₂H₅)₃, CH₂=CHSiCH₃(OCH₃)₂, CH₂=CHSi(OCOCH₃)₃, CH₂=CHSi(CH₃)₂(OC₂H₅), CH₂=CHSi(CH₃)₂SiCH₃(OCH₃)₂, CH₂=CHSiC₂H₅(OCOCH₃)₂, and CH₂=CHSiCH₃[ON(CH₃)C₂H₅]₂, vinyltrichlorosilane, and the partial hydrolyzates of the preceding; and vinyl ethers such as trimethoxysilylethyl vinyl ether, triethoxysilylethyl vinyl ether, trimethoxysilylbutyl vinyl ether, methyldimethoxysilylethyl vinyl ether, trimethoxysilylpropyl vinyl ether, and triethoxysilylpropyl vinyl ether.

The fluorine-containing monomer, i.e., the monomer for forming a fluorinated polymer into which a curable functional group has been introduced, can be exemplified by tetrafluoroethylene, chlorotrifluoroethylene, vinylidene fluoride, vinyl fluoride, and fluorovinyl ether, and a single one of these may be used or two or more may be used.

Preferred among the preceding is at least one selection from the group consisting of tetrafluoroethylene, chlorotrifluoroethylene, and vinylidene fluoride, while at least one selection from the group consisting of tetrafluoroethylene and chlorotrifluoroethylene is even more preferred.

The fluorinated polymer into which a curable functional group has been introduced can be exemplified by the following, categorized according to the polymerization units constituting the polymer.

### (1) Perfluoroolefin-based polymers that mainly contain a perfluoroolefin unit:

These can be specifically exemplified by tetrafluoroethylene (TFE) homopolymers, copolymers between TFE and, e.g., hexafluoropropylene (HFP) or perfluoro(alkyl vinyl ether) (PAVE), and copolymers of the preceding with another copolymerizable monomer.

This other copolymerizable monomer can be exemplified by vinyl carboxylate esters such as vinyl acetate, vinyl propionate, vinyl butyrate, vinyl isobutyrate, vinyl pivalate, vinyl caproate, vinyl versatate, vinyl laurate, vinyl stearate, vinyl cyclohexylcarboxylate, vinyl benzoate, and vinyl para-t-butylbenzoate; alkyl vinyl ethers such as methyl vinyl ether, ethyl vinyl ether, butyl vinyl ether, and cyclohexyl vinyl ether; fluorine-free olefins such as ethylene, propylene, n-butene, and isobutene; and fluorine-containing monomers such as vinylidene fluoride (VdF), chlorotrifluoroethylene (CTFE), vinyl fluoride (VF), and fluorovinyl ether, but there is no limitation to only these.

Among the preceding, TFE-based polymers that mainly contain TFE are preferred for their excellent pigment dispersibility, excellent weathering resistance, excellent copolymerizability, and excellent chemical resistance.

Curable functional group-containing perfluoroolefin-based polymers can be specifically exemplified by copolymers of TFE/isobutylene/hydroxybutyl vinyl ether/other monomer, copolymers of TFE/vinyl versatate/hydroxybutyl vinyl ether/other monomer, and copolymers of TFE/VdF/hydroxybutyl vinyl ether/other monomer, while copolymers of TFE/isobutylene/hydroxybutyl vinyl ether/other monomer and copolymers of TFE/vinyl versatate/hydroxybutyl vinyl ether/other monomer are preferred.

An example of a TFE-based curable polymer composition for application as a coating material is the Zeffle GK series from Daikin Industries, Ltd.

### (2) CTFE-based polymers that mainly contain the chlorotrifluoroethylene (CTFE) unit:

Specific examples here are copolymers of CTFE/hydroxybutyl vinyl ether/other monomer.

Examples of CTFE-based curable polymer compositions for application as a coating material are Lumiflon from Asahi Glass Co., Ltd., Fluonate from the DIC Corporation, Cefral Coat from Central Glass Co., Ltd., and Zaflon from Toagosei Co., Ltd.

### (3) VdF-based polymers that mainly contain the vinylidene fluoride (VdF) unit:

Specific examples here are VdF/TFE/hydroxybutyl vinyl ether/other monomer copolymers.

### (4) Fluoroalkyl group-containing polymers that mainly contain a fluoroalkyl unit:

Specific examples here are CF₃CF₂(CF₂CF₂)ₙCH₂CH₂OCOCH=CH₂ (n = mixture of 3 and 4)/2-hydroxyethyl methacrylate/stearyl acrylate copolymers.

The fluoroalkyl group-containing polymer can be exemplified by Unidyne and Ftone, both from Daikin Industries, Ltd., and Zonyl from Du Pont Co., Ltd..

Among the preceding, the perfluoroolefin-based polymers are preferred when one considers the weathering resistance and moistureproofness.

The curable functional group-containing fluorinated polymer can be prepared, for example, by the method disclosed in JP-A 2004-204205.

The content of the curable functional group-containing fluorinated polymer in the coating material for the present invention is preferably 20 to 100 mass% where the total amount of nonvolatile components in the coating material is 100 mass%.

The coating material for the present invention preferably contains a curing agent.

This curing agent is selected in conformity to the functional group in the curable polymer, and, for example, for a hydroxyl group-containing fluorinated polymer, preferred examples are isocyanate-based curing agents, melamine resins, silicate compounds, and isocyanate group-containing silane compounds. In addition, amino-based curing agents and epoxy-based curing agents are typically adopted for carboxyl group-containing fluorinated polymers, while carbonyl group-containing curing agents, epoxy-based curing agents, and acid anhydride-based curing agents are typically adopted for amino group-containing fluorinated polymers.

Among the preceding, the curing agent is preferably at least one compound selected from the group consisting of polyisocyanate compounds derived from at least one isocyanate selected from the group consisting of xylylene diisocyanate (XDI) and bis(isocyanatomethyl)cyclohexane (hydrogenated XDI, H6XDI), blocked isocyanate compounds based on hexamethylene diisocyanate (HDI), polyisocyanate compounds derived from hexamethylene diisocyanate (HDI), and polyisocyanate compounds derived from isophorone diisocyanate (IPDI).

The cured coating film obtained from the coating material for the present invention is endowed with an excellent adherence with the sealant in the solar cell module through the use as the curing agent of a polyisocyanate compound (also referred to below as the polyisocyanate compound (I)) derived from at least one isocyanate (also referred to below as the isocyanate (i)) selected from the group consisting of xylylene diisocyanate (XDI) and bis(isocyanatomethyl)cyclohexane (hydrogenated XDI, H6XDI). Moreover, a solar cell module backsheet having such a cured coating film will exhibit an excellent resistance to blocking with respect to surfaces that this cured coating film comes into contact with during, e.g., a winding step.

The polyisocyanate compound (I) can be exemplified by adducts obtained by an addition polymerization between the isocyanate (i) and a trihydric or higher hydric aliphatic polyhydric alcohol, by isocyanurate structures (nurate structures) formed from the isocyanate (i), and by biurets formed from the isocyanate (i).

The adduct referenced above, for example, preferably has the structure represented by the following general formula (3)

[Chem. 3] R¹(̵OCONH-CH₂-R²-CH₂-NCO)ₖ (3)

(in the formula, R¹ represents a C₃₋₂₀ aliphatic hydrocarbyl group; R² represents the phenylene group or cyclohexylene group; and k is an integer from 3 to 20).

The R¹ in general formula (3) is a hydrocarbyl group based on the trihydric or higher hydric aliphatic polyhydric alcohol and more preferably is a C₃₋₁₀ aliphatic hydrocarbyl group and even more preferably is a C₃₋₆ aliphatic hydrocarbyl group.

When R² is the phenylene group, it may be the 1,2-phenylene group (o-phenylene group), 1,3-phenylene group (m-phenylene group), or 1,4-phenylene group (p-phenylene group). The 1,3-phenylene group (m-phenylene group) is preferred among these. The R² in general formula (3) may all be the same phenylene group, or a mixture of two or more phenylene group species may be present.

When R² is the cyclohexylene group, it may be the 1,2-cyclohexylene group, 1,3-cyclohexylene group, or 1,4-cyclohexylene group. The 1,3-cyclohexylene group is preferred among these. The R² in general formula (3) may all be the same cyclohexylene group, or a mixture of two or more cyclohexylene group species may be present.

k is a number corresponding to the valence of the trihydric or higher hydric aliphatic polyhydric alcohol. This k is more preferably an integer from 3 to 10 and even more preferably is an integer from 3 to 6.

The isocyanurate structure referenced above has one or two or more isocyanurate rings represented by the following general formula (4) 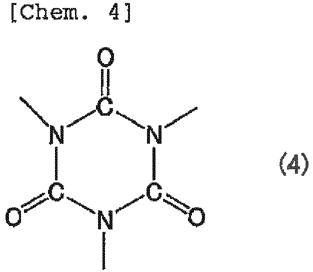 in the molecule.

This isocyanurate structure can be exemplified by the trimer provided by a trimerization reaction of the isocyanate (i), the pentamer provided by its pentamerization reaction, and the heptamer provided by its heptamerization reaction.

The trimer represented by the following general formula (5)

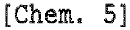

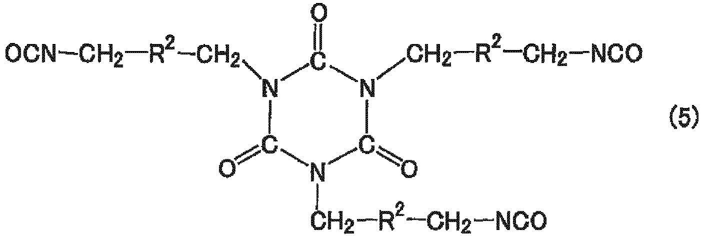

(R² in the formula is the same as the R² in general formula (3)) is preferred among the preceding. Thus, the isocyanurate structure is preferably a trimer of the at least one isocyanate (i) selected from the group consisting of xylylene diisocyanate and bis(isocyanatomethyl)cyclohexane.

The biuret is a compound having the structure represented by the following general formula (6)

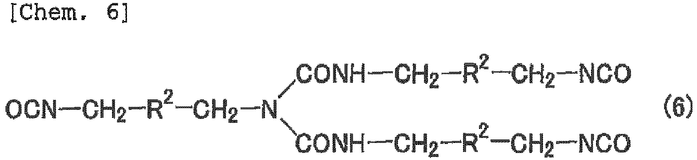

(R² in the formula is the same as the R² in general formula (3)) and can be obtained by the trimerization of the isocyanate (i) under conditions different from those for obtaining the isocyanurate.

Among the preceding, the polyisocyanate compound (I) is preferably the adduct described above, i.e., is obtained by the addition polymerization of a trihydric or higher hydric aliphatic polyhydric alcohol with the at least one isocyanate (i) selected from the group consisting of xylylene diisocyanate and bis(isocyanatomethyl)cyclohexane.

When the polyisocyanate compound (I) is an adduct between the isocyanate (i) and a trihydric or higher hydric aliphatic polyhydric alcohol, this trihydric or higher hydric aliphatic polyhydric alcohol can be specifically exemplified by trihydric alcohols such as glycerol, trimethylolpropane (TMP), 1,2,6-hexanetriol, trimethylolethane, 2,4-dihydroxy-3-hydroxymethylpentane, 1,1,1-tris(bishydroxymethyl)propane, and 2,2-bis(hydroxymethyl)butan-3-ol; tetrahydric alcohols such as pentaerythritol and diglycerol; pentahydric alcohols (pentitols) such as arabitol, ribitol, and xylitol; and hexahydric alcohols (hexitols) such as sorbitol, mannitol, galactitol, and allodulcitol. Trimethylolpropane and pentaerythritol are particularly preferred among the preceding.

The xylylene diisocyanate (XDI) that may be used as a constituent component of this adduct can be exemplified by 1,3-xylylene diisocyanate (m-xylylene diisocyanate), 1,2-xylylene diisocyanate (o-xylylene diisocyanate), and 1,4-xylylene diisocyanate (p-xylylene diisocyanate), whereamong 1,3-xylylene diisocyanate (m-xylylene diisocyanate) is preferred.

The bis(isocyanatomethyl)cyclohexane (hydrogenated XDI, H6XDI) that may be used as a constituent component of this adduct can be exemplified by 1,3-bis(isocyanatomethyl)cyclohexane, 1,2-bis(isocyanatomethyl)cyclohexane, and 1,4-bis(isocyanatomethyl)cyclohexane, whereamong 1,3-bis(isocyanatomethyl)cyclohexane is preferred.

An adduct favorable for use in the present invention is obtained by the addition polymerization of the previously described trihydric or higher hydric aliphatic polyhydric alcohol with the at least one isocyanate (i) selected from the group consisting of xylylene diisocyanate and bis(isocyanatomethyl)cyclohexane.

A specific example of an adduct preferred for use in the present invention is a compound represented by the following general formula (7)

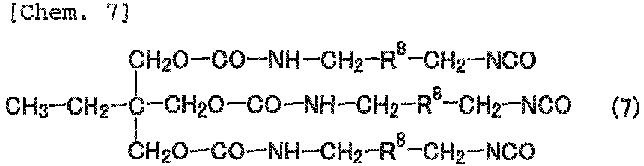

(R⁸ in the formula represents the phenylene group or cyclohexylene group), i.e., a polyisocyanate compound obtained by the addition polymerization of trimethylolpropane (TMP) and the at least one isocyanate (i) selected from the group consisting of xylylene diisocyanate and bis(isocyanatomethyl)cyclohexane.

The phenylene group or cyclohexylene group represented by R⁸ in general formula (7) is the same as cited for the R² in general formula (3).

Commercially available products for the polyisocyanate compound with general formula (7) can be exemplified by Takenate D110N (from Mitsui Chemicals, Inc., an XDI/TMP adduct, NCO content = 11.8%) and Takenate D120N (from Mitsui Chemicals, Inc., an H6XDI/TMP adduct, NCO content = 11.0%).

Specific examples of the polyisocyanate compound (I) when it has an isocyanurate structure are Takenate D121N (from Mitsui Chemicals, Inc., H6XDInurate, NCO content = 14.0%) and Takenate D127N (from Mitsui Chemicals, Inc., H6XDInurate, trimer of H6XDI, NCO content = 13.5%).

The use of a hexamethylene diisocyanate (HDI)-based blocked isocyanate (also referred to herebelow simply as a blocked isocyanate) as the curing agent provides a coating material for the present invention that has a satisfactory pot life (use time).

This blocked isocyanate is preferably a blocked isocyanate obtained by reacting a hexamethylene diisocyanate-derived polyisocyanate compound (also referred to below as the polyisocyanate compound (II)) with a blocking agent.

This polyisocyanate compound (II) can be exemplified by adducts obtained by the addition polymerization of hexamethylene diisocyanate with a trihydric or higher hydric aliphatic polyhydric alcohol, by isocyanurate structures (nurate structures) formed from hexamethylene diisocyanate, and by biurets formed from hexamethylene diisocyanate.

This adduct is preferably, for example, an adduct having the structure represented by the following general formula (8)

[Chem. 8] R⁹(̵OCONH-(CH₂)₆-NCO)ₖ (8)

(in the formula, R⁹ represents a C₃₋₂₀ aliphatic hydrocarbyl group and k is an integer from 3 to 20).

R⁹ in general formula (8) is a hydrocarbyl group that is based on the trihydric or higher hydric aliphatic polyhydric alcohol, and is more preferably a C₃₋₁₀ aliphatic hydrocarbyl group and is even more preferably a C₃₋₆ aliphatic hydrocarbyl group.

The aforementioned k is a number that corresponds to the valence of the trihydric or higher hydric aliphatic polyhydric alcohol. This k is more preferably an integer from 3 to 10 and is even more preferably an integer from 3 to 6.

The isocyanurate structure cited above has one or two or more isocyanurate rings represented by the following general formula (4) 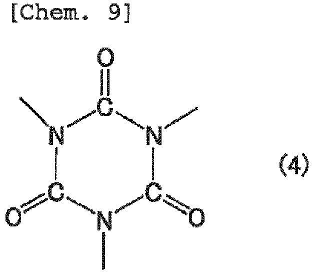 in the molecule.

This isocyanurate structure can be exemplified by the trimer provided by a trimerization reaction of the isocyanate, the pentamer provided by its pentamerization reaction, and the heptamer provided by its heptamerization reaction.

The trimer represented by the following general formula (9) 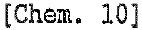 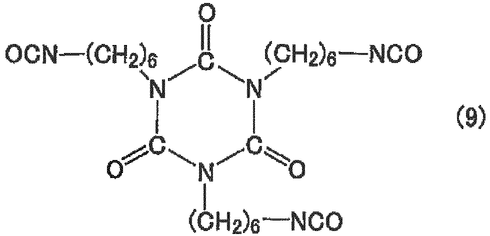 is preferred among the preceding.

The biuret is a compound having the structure represented by the following general formula (10) 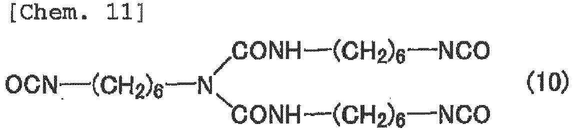 and can be obtained by the trimerization of hexamethylene diisocyanate under conditions different from those for obtaining the isocyanurate structure cited above.

A compound having active hydrogen is preferably used as the blocking agent. At least one selection from the group consisting of alcohols, oximes, lactams, active methylene compounds, and pyrazole compounds is preferably used as this active hydrogen-bearing compound.

The blocked isocyanate here is obtained by reacting the blocking agent with the hexamethylene diisocyanate-derived polyisocyanate compound, and this blocking agent being at least one selection from the group consisting of alcohols, oximes, lactams, active methylene compounds, and pyrazole compounds is a preferred embodiment of the present invention.

When the polyisocyanate compound (II) used to obtain the blocked isocyanate is itself an adduct of hexamethylene diisocyanate with a trihydric or higher hydric aliphatic polyhydric alcohol, this trihydric or higher hydric aliphatic polyhydric alcohol can be specifically exemplified by trihydric alcohols such as glycerol, trimethylolpropane (TMP), 1,2,6-hexanetriol, trimethylolethane, 2,4-dihydroxy-3-hydroxymethylpentane, 1,1,1-tris(bishydroxymethyl)propane, and 2,2-bis(hydroxymethyl)butan-3-ol; tetrahydric alcohols such as pentaerythritol and diglycerol; pentahydric alcohols (pentitols) such as arabitol, ribitol, and xylitol; and hexahydric alcohols (hexitols) such as sorbitol, mannitol, galactitol, and allodulcitol. Trimethylolpropane and pentaerythritol are particularly preferred among the preceding.

This adduct can be obtained by an addition polymerization between hexamethylene diisocyanate and the trihydric or higher hydric aliphatic polyhydric alcohol as described above.

The active hydrogen-bearing compound that is reacted with the polyisocyanate compound (II) can be specifically exemplified by alcohols such as methanol, ethanol, n-propanol, isopropanol, and methoxypropanol; oximes such as acetone oxime, 2-butanone oxime, and cyclohexanone oxime; lactams such as ε-caprolactam; active methylene compounds such as methyl acetoacetate and ethyl malonate; and pyrazole compounds such as 3-methylpyrazole, 3,5-dimethylpyrazole, and 3,5-diethylpyrazole, and a single one of these may be used or two or more may be used.

Active methylene compounds and oximes are preferred among the preceding, and active methylene compounds are more preferred.

These blocked isocyanates are commercially available as, for example, Duranate K6000 (Asahi Kasei Chemicals Corporation, active methylene compound-blocked isocyanate from HDI), Duranate TPA-B80E (Asahi Kasei Chemicals Corporation), Duranate MF-B60X (Asahi Kasei Chemicals Corporation), Duranate 17B-60PX (Asahi Kasei Chemicals Corporation), Coronate 2507 (Nippon Polyurethane Industry Co., Ltd.), Coronate 2513 (Nippon Polyurethane Industry Co., Ltd.), Coronate 2515 (Nippon Polyurethane Industry Co., Ltd.), Sumidur BL-3175 (Sumika Bayer Urethane Co., Ltd.), Luxate HC1170 (Olin Chemicals), and Luxate HC2170 (Olin Chemicals).

A hexamethylene diisocyanate (HDI)-derived polyisocyanate compound (also referred to herebelow as the polyisocyanate compound (III)) may also be used as a curing agent. This polyisocyanate compound (III) can be exemplified by the previously described polyisocyanate compounds (II). An isocyanurate structure formed from hexamethylene diisocyanate is preferred among the preceding.

The polyisocyanate compound (III) can be specifically exemplified by Coronate HX (Nippon Polyurethane Industry Co., Ltd., an isocyanurate structure from hexamethylene diisocyanate, NCO content = 21.1%), Sumidur N3300 (Sumika Bayer Urethane Co., Ltd., isocyanurate structure from hexamethylene diisocyanate), and Takenate D170N (Mitsui Chemicals, Inc., isocyanurate structure from hexamethylene diisocyanate).

Through the use of an isophorone diisocyanate (IPDI)-derived polyisocyanate compound (also referred to herebelow as the polyisocyanate compound (IV)) as a curing agent, the solar cell module backsheet having a cured coating film obtained from the coating material for the present invention can be provided with an excellent resistance to blocking versus surfaces with which the cured coating film is in contact during, for example, a winding step.

This polyisocyanate compound (IV) can be exemplified by adducts obtained by the addition polymerization of isophorone diisocyanate with a trihydric or higher hydric aliphatic polyhydric alcohol, by isocyanurate structures (nurate structures) formed from isophorone diisocyanate, and by biurets formed from isophorone diisocyanate.

This adduct is preferably, for example, an adduct having the structure represented by the following general formula (11)

[Chem. 12] R¹⁰(̵OCONH-R¹¹-NCO)ₖ (11)

(in the formula, R¹⁰ represents a C₃₋₂₀ aliphatic hydrocarbyl group, R¹¹ is a group represented by the following general formula (12) 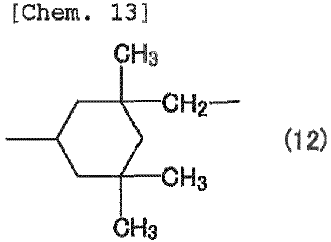 and k is an integer from 3 to 20).

R¹⁰ in general formula (11) is a hydrocarbyl group that is based on the trihydric or higher hydric aliphatic polyhydric alcohol, and is more preferably a C₃₋₁₀ aliphatic hydrocarbyl group and is even more preferably a C₃₋₆ aliphatic hydrocarbyl group.

The aforementioned k is a number that corresponds to the valence of the trihydric or higher hydric aliphatic polyhydric alcohol. This k is more preferably an integer from 3 to 10 and is even more preferably an integer from 3 to 6.

The isocyanurate structure cited above has one or two or more isocyanurate rings represented by the following general formula (4) 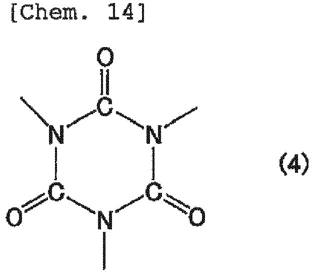 in the molecule.

This isocyanurate structure can be exemplified by the trimer provided by a trimerization reaction of isophorone diisocyanate, the pentamer provided by its pentamerization reaction, and the heptamer provided by its heptamerization reaction.

Following general formula (13)

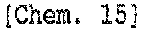

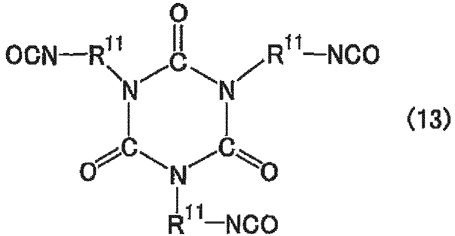

(R¹¹ in the formula is the same as the R¹¹ in general formula (11)) is preferred among the preceding. Thus, this isocyanurate structure is preferably a trimer of isophorone diisocyanate.

The biuret is a compound having the structure represented by the following general formula (14)

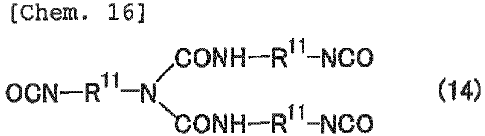

(R¹¹ in the formula is the same as the R¹¹ in general formula (11)) and can be obtained by the trimerization of isophorone isocyanate under conditions different from those for obtaining the isocyanurate.

Among the preceding, the polyisocyanate compound (IV) is preferably at least one selection from the group consisting of the adducts and isocyanurate structures described in the preceding. Thus, the polyisocyanate compound (IV) is preferably at least one selection from the group consisting of adducts obtained by the addition polymerization of isophorone diisocyanate with a trihydric or higher hydric aliphatic polyhydric alcohol and isocyanurate structures formed from isophorone diisocyanate.

When the polyisocyanate compound (IV) is an adduct between isophorone diisocyanate and a trihydric or higher hydric aliphatic polyhydric alcohol, this trihydric or higher hydric aliphatic polyhydric alcohol can be specifically exemplified by trihydric alcohols such as glycerol, trimethylolpropane (TMP), 1,2,6-hexanetriol, trimethylolethane, 2,4-dihydroxy-3-hydroxymethylpentane, 1,1,1-tris(bishydroxymethyl)propane, and 2,2-bis(hydroxymethyl)butan-3-ol; tetrahydric alcohols such as pentaerythritol and diglycerol; pentahydric alcohols (pentitols) such as arabitol, ribitol, and xylitol; and hexahydric alcohols (hexitols) such as sorbitol, mannitol, galactitol, and allodulcitol. Trimethylolpropane and pentaerythritol are most preferred among the preceding.

An adduct favorable for use in the present invention is obtained by the addition polymerization of isophorone diisocyanate with such a trihydric or higher hydric aliphatic polyhydric alcohol.

A specific example of an adduct preferred for use in the present invention is a compound represented by the following general formula (15)

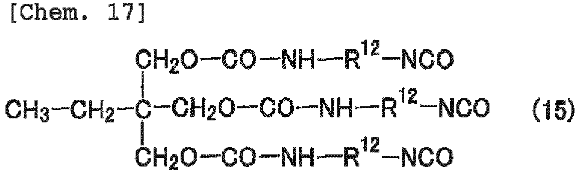

(R¹² in the formula is a group represented by the following general formula (12)) 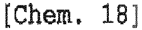 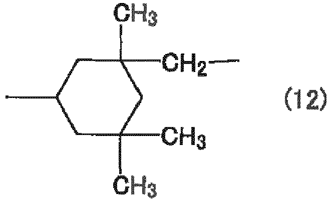 i.e., a polyisocyanate compound obtained by the addition polymerization of isophorone diisocyanate and trimethylolpropane (TMP).

The polyisocyanate compound represented by general formula (12) (the TMP adduct of isophorone diisocyanate) is commercially available as, for example, Takenate D140N (Mitsui Chemicals, Inc., NCO content = 11%).

An isocyanurate structure formed from isophorone diisocyanate is commercially available as, for example, Desmodur Z4470 (Sumika Bayer Urethane Co., Ltd., NCO content = 11%).

The curing agent is more preferably at least one compound selected from the group consisting of polyisocyanate compounds derived from at least one isocyanate selected from the group consisting of xylylene diisocyanate (XDI) and bis(isocyanatomethyl)cyclohexane (hydrogenated XDI, H6XDI), blocked isocyanate compounds based on hexamethylene diisocyanate (HDI), and polyisocyanate compounds derived from isophorone diisocyanate (IPDI).

When the coating material for the present invention contains the polyisocyanate compound (I) derived from the at least one isocyanate (i) selected from the group consisting of xylylene diisocyanate and bis(isocyanatomethyl)cyclohexane, the coating film obtained from this coating material exhibits an excellent adherence with the EVA generally used as a sealant in solar cell modules and also exhibits an excellent blocking resistance when wound and as a consequence can be favorably used for coating a solar cell module backsheet that is typically produced using a winding step.

As described below, this coating film may be formed on one side or both sides of the water-impermeable sheet in a solar cell module backsheet.

In instances where a coating film obtained from the coating material for the present invention is formed on one surface of the water-impermeable sheet and the other surface of the water-impermeable sheet remains an uncoated surface, the coating film will then be placed in contact with the uncoated surface of the water-impermeable sheet during a winding step. In instances, on the other hand, where this coating film is formed on one surface of the water-impermeable sheet and a coating film from another coating material (as described below, a cured coating film from a curable functional group-free fluorinated polymer coating material, a coating film from a polyester coating material, a primer layer, and so forth) or another sheet is disposed on the other side of the water-impermeable sheet, the coating film obtained from the coating material for the present invention will then be placed in contact during a winding step with the other sheet or with the other coating material-derived coating film on the water-impermeable sheet. In addition, in instances where the coating film obtained from the coating material for the present invention is formed on both surfaces of the water-impermeable sheet, this coating film will then be placed in contact during a winding step with the same kind of coating film formed on the other surface of the water-impermeable sheet.

When the coating material for the present invention contains the polyisocyanate compound (I), the coating film obtained from this coating material can in all of these instances exhibit an excellent blocking resistance with respect to the surface in contact with it.

When the coating material for the present invention contains the polyisocyanate compound (IV) derived from isophorone diisocyanate (IPDI), the coating film obtained from this coating material will exhibit an excellent blocking resistance when wound. When formed on one side or both sides of the water-impermeable sheet, this coating film can, just as described above, also exhibit an excellent blocking resistance with respect to the surface in contact with it.

When the coating material for the present invention contains the blocked isocyanate based on hexamethylene diisocyanate (HDI), this coating material then has a pot life that is substantially improved over that of conventional curable functional group-containing fluorinated polymer coating materials. The pot life, which indicates the time during which the coating material can be used, is a critical feature in terms of raising the degree of freedom for a process. A longer pot life for a coating material makes possible its use even in applications where relatively long times are required for coating. In addition, the fluidity of the coating material during processing can be secured even in instances where the coating material must be transported or temporarily stored after it has been prepared. Such a coating material is also very useful for coating a solar cell module backsheet in those instances where conventional curable functional group-containing fluorinated polymer coating materials have been suitably used.

The curing agent is particularly preferably at least one compound selected from the group consisting of hexamethylene diisocyanate (HDI)-based blocked isocyanate compounds and polyisocyanate compounds derived from at least one isocyanate selected from the group consisting of xylylene diisocyanate (XDI) and bis(isocyanatomethyl)cyclohexane (hydrogenated XDI, H6XDI).

The content of the curing agent of the coating material is preferably 0.1 to 5 equivalents and more preferably 0.5 to 1.5 equivalents per 1 equivalent of the curable functional groups in curable functional group-containing fluorinated polymer.

The content of the curable functional group in the curable functional group-containing fluorinated polymer can be determined using a suitable combination, depending on the kind of monomer, of NMR, FT-IR, elemental analysis, and x-ray fluorescence analysis.

The coating material according to the present invention can be prepared by the usual methods, formulated as, for example, a solvent-type coating material, water-based coating material, powder coating material, and so forth. Among these, solvent-based coating material formulations are preferred from the standpoints of the ease of film formation, curability, and excellence in drying.

The solvent in the solvent-based coating material is preferably an organic solvent and can be exemplified by esters such as ethyl acetate, butyl acetate, isopropyl acetate, isobutyl acetate, cellosolve acetate, and propylene glycol methyl ether acetate; ketones such as acetone, methyl ethyl ketone, methyl isobutyl ketone, and cyclohexanone; cyclic ethers such as tetrahydrofuran and dioxane; amides such as N,N-dimethylformamide and N,N-dimethylacetamide; aromatic hydrocarbons such as xylene, toluene, and solvent naphtha; glycol ethers such as propylene glycol methyl ether, and ethyl cellosolve; diethylene glycol esters such as carbitol acetate; aliphatic hydrocarbons such as n-pentane, n-hexane, n-heptane, n-octane, n-nonane, n-decane, n-undecane, n-dodecane, and mineral spirits; and mixed solvents of the preceding.

The esters are preferred among the preceding, and butyl acetate is particularly preferred.

When the coating material according to the present invention is formulated as a solvent-based coating material, the concentration of the curable functional group-containing fluorinated polymer is preferably 5 to 95 weight% and more preferably 10 to 70 weight% where the total amount of the coating material is 100 mass%.

Various additives may additionally be incorporated in the coating material of the present invention in conformity with the properties required thereof. These additives can be exemplified by curing accelerators, pigments, pigment dispersants, defoamants, leveling agents, ultraviolet absorbers, light stabilizers, thickeners, adhesion promoters, matting agents, and so forth.

The curing accelerator can be exemplified by organotin compounds, acidic phosphate esters, reaction products from an acidic phosphate ester and amine, saturated and unsaturated polybasic carboxylic acids and their anhydrides, organotitanate compounds, amine compounds, and lead octylate.

A single curing accelerator may be used or two or more may be used in combination. The curing accelerator is incorporated, expressed per 100 weight parts of the curable functional group-containing fluorinated polymer, preferably at approximately 1.0 × 10⁻⁶ to 1.0 × 10⁻² weight parts and more preferably at approximately 5.0 × 10⁻⁵ to 1.0 × 10⁻³ weight parts.

The coating material according to the present invention preferably also contains a pigment. This serves to endow the resulting cured coating film with an excellent UV-blocking performance. The addition of a pigment is also highly desirable from the standpoint of providing the solar cell module with an aesthetically pleasing appearance.

The pigment can be specifically exemplified by inorganic pigments, e.g., titanium oxide and calcium carbonate, which are white pigments, and carbon black and composite metals such as Cu-Cr-Mn alloys, which are black pigments, and by organic pigments such as phthalocyanine compounds, quinacridone compounds, and azo compounds; however, there is no limitation to only these.

The amount of pigment addition, expressed per 100 weight parts of the curable functional group-containing fluorinated polymer, is preferably 0.1 to 200 weight parts and is more preferably 0.1 to 160 weight parts.

The coating material according to the present invention preferably additionally contains an ultraviolet absorber. Because solar cells are used on a long-term basis outdoors under strong ultraviolet exposure, countermeasures are required to the ultraviolet-induced degradation of the backsheet. The addition of an ultraviolet absorber to the coating material according to the present invention can impart an ultraviolet-absorbing capacity to the cured coating film layer.

An organic or inorganic ultraviolet absorber can be used as the ultraviolet absorber. The organic compounds can be exemplified by salicylate esters, benzotriazoles, benzophenones, and cyanoacrylates, while filler-type inorganic ultraviolet absorbers such as zinc oxide, cerium oxide, and so forth are preferred for the inorganic compounds.

A single ultraviolet absorber may be used by itself or a combination of two or more may be used. The amount of the ultraviolet absorber is preferably 0.1 to 15 mass% where 100 mass% is the total amount of the curable functional group-containing fluorinated polymer in the coating material. A satisfactory improvement in the light resistance is not obtained when the amount of the ultraviolet absorber is too small, while the effect is saturated when the amount of the ultraviolet absorber is too large.

The coating film for the present invention can be formed by coating the coating material on the water-impermeable sheet and curing. Formation of the cured coating film on the water-impermeable sheet is carried out by coating the water-impermeable sheet with the coating material for the present invention in conformity with the formulation of this coating material.

Coating may be carried out within the range of ordinary temperature conditions for the coating regime, and, in the case of a solvent-based coating material, curing and drying are performed at 10°C to 300°C and generally 100°C to 200°C for 30 seconds to 3 days. Accordingly, materials for which a high-temperature process is desirably avoided, such as Si-deposited PET sheet, can be unproblematically used as the water-impermeable sheet constituting a backsheet for a solar cell module according to the present invention. An aftercure may be performed after curing and drying, and this aftercure is typically completed at 20°C to 300°C in 1 minute to 3 days.

Coating of the water-impermeable sheet may be performed by direct application of the coating material according to the present invention to the water-impermeable sheet or by application across, for example, a primer layer.

Such a primer layer may be formed by the usual methods using a heretofore known primer coating material. Epoxy resins, urethane resins, acrylic resins, silicone resins, and polyester resins are typical examples of primer coating materials.

The degree of crosslinking for the coating film for the present invention, calculated using the gel fraction in Soxhlet extraction using acetone, is preferably 90% to 100%, more preferably 95% to 100%, and even more preferably 98% to 100%.

The film thickness of the cured coating film is preferably made at least 5 µm from the standpoint of obtaining an excellent hiding power, weathering resistance, chemical resistance, and moisture resistance. At least 7 µm is more preferred and at least 10 µm is even more preferred. Because weight reduction is not achieved when the cured coating film is overly thick, the upper limit is preferably about 1000 µm and more preferably 100 µm. A film thickness of 10 to 40 µm is particularly preferred.

A first surface treatment layer is formed on the coating film for the present invention at least on the surface on the opposite side to the water-impermeable sheet, and this first surface treatment layer has a wetting index of at least 40 dyn/cm. By doing this, the infiltration of, e.g., rain water, from between the adhesion layer and the first surface treatment layer can be prevented when an adhesion layer, infra, is disposed on the first surface treatment layer.

The wetting index for the first surface treatment layer is preferably at least 42 dyn/cm and more preferably at least 45 dyn/cm. This wetting index is preferably not more than 65 dyn/cm and is more preferably not more than 60 dyn/cm.

This first surface treatment layer is a layer obtained by the execution of a surface treatment on the coating film. This surface treatment can be exemplified by corona discharge treatments, plasma discharge treatments, chemical conversion treatments, and blast treatments. Heretofore known methods may be employed for all of these treatments.

Among the preceding, the first surface treatment layer is preferably obtained by a corona discharge treatment and/or a plasma discharge treatment. The discharge in the corona discharge treatment and plasma discharge treatment is preferably carried out at a line speed of 5 to 1000 m/minute and a discharge intensity of 0.1 to 10 kW. The line speed is more preferably 10 to 1000 m/minute and is even more preferably 10 to 900 m/minute. The discharge intensity is more preferably 0.1 to 8 kW and is even more preferably 0.1 to 6 kW.

The treatment temperature can be freely established in the range from a lower limit of 0°C to an upper limit of 100°C.

The first surface treatment layer may be formed on only the on the surface of the coating film on the opposite side to the water-impermeable sheet or may be formed on both sides of the coating film.

This water-impermeable sheet constituting a backsheet for a solar cell module according to the present invention is a layer disposed to prevent the permeation of moisture into the sealant and solar cell. Any material that substantially does not permeate water can be used, but, viewed in terms of weight, cost, and flexibility, PET sheet, Si-deposited PET sheet, and thin metal sheet, e.g., of aluminum, stainless steel, and so forth, are often used. PET sheet is frequently used among the preceding. The thickness is generally about 50 to 250 µm. An Si-deposited PET sheet is frequently used when moistureproofness is a particular requirement. This thickness is generally about 10 to 20 µm.

A heretofore known surface treatment may be carried out on the water-impermeable sheet in order to improve the adhesiveness with the coating film. This surface treatment can be exemplified by corona discharge treatments, plasma discharge treatments, chemical conversion treatments, and, in the case of a metal sheet, blast treatments.

The coating film having the first surface treatment layer formed thereon should be formed on at least one side of the water-impermeable sheet in the backsheet of the present invention. Nothing, a coating film formed from the previously described coating material containing a curable functional group-containing fluorinated polymer (a coating film formed from the coating material for the present invention), or a layer of another coating material may be disposed on the surface on the opposite side of the water-impermeable sheet to the coating film having the first surface treatment layer formed thereon. An adhesive-containing adhesive layer as described below is an example of the layer of another coating material. A second surface treatment layer obtained by the execution of a surface treatment may also be formed on a layer disposed on the surface of the water-impermeable sheet on the opposite side to the coating film having the first surface treatment layer formed thereon.

Viewed from the standpoint of bringing about a sufficient manifestation of the effects of the present invention, the first surface treatment layer is preferably the outermost layer for the backsheet of the present invention.

The present invention is also a laminate that contains the backsheet as described above, an adhesion layer, and a junction box, wherein the adhesion layer is disposed on the first surface treatment layer of the backsheet and the junction box is a laminate disposed on the surface of the adhesion layer on the opposite side the backsheet.

This adhesion layer is provided in order to bond the backsheet of the present invention with the junction box and is disposed to be in contact with the first surface treatment layer in the backsheet, i.e., with a surface treatment layer that has a wetting index of at least 40 dyn/cm. Doing this impedes the infiltration of, for example, rain water, between the adhesion layer and the backsheet and can thereby prevent the corrosion of the electrodes and wiring for taking off the power output from the solar cell.

The adhesion layer should be able to adhere the backsheet of the present invention to the junction box, but is not otherwise particularly limited; however, at least one selection from the group consisting of silicone resins, acrylic resins, and urethane resins is preferred.

The junction box is a box that houses items such as the electrodes and wiring for taking off the power output from the solar cell (electrodes and wiring connected to the solar cell) and terminals that connect to cabling for removing the output power to the outside of the solar cell module. The shape and material of the junction box should be capable of protecting the terminals housed therein, but is not otherwise limited and heretofore known shapes and materials may be adopted.

The junction box is disposed on the surface of the adhesion layer on the opposite side to the backsheet. The method for placing the junction box can be exemplified by a method in which an adhesive coating film of a composition containing a material as described above is formed on the first surface treatment layer on the backsheet and a junction box provided with the necessary terminals is placed thereon.

The present invention is also a solar cell module that has the laminate described above and a sealant layer that seals a solar cell and is disposed on the opposite side of the backsheet to the junction box.

Since the solar cell module of the present invention has the laminate described above, the infiltration of, e.g., rain water, from between the backsheet and the adhesion layer that bonds the junction box is impeded and the corrosion of the electrodes and wiring for taking off the output power can be effectively prevented even during long-term use outdoors.

The sealant layer here is a layer that seals the solar cell and is preferably constituted of, for example, an ethylene/vinyl acetate copolymer (EVA), polyvinyl butyral (PVB), silicone resin, epoxy resin, or acrylic resin. The use of EVA is preferred among the preceding.

This sealant layer is disposed on the opposite side of the backsheet of the laminate to the junction box. The sealant layer may be in direct contact with the side - of the water-impermeable sheet of the backsheet - that is the opposite side to the junction box, or an intermediate layer may be disposed between the water-impermeable sheet and the sealant layer.

This intermediate layer can be exemplified by the previously described coating film formed from a curable functional group-containing fluorinated polymer, by an adhesive layer containing an adhesive, and so forth. There are no particular limitations on the adhesive present in this adhesive layer, but it is preferably at least one selection from the group consisting of polyester adhesives, urethane adhesives, epoxy adhesives, nylon adhesives, ethylene-vinyl acetate adhesives, acrylic adhesives, and rubber-based adhesives.

Among the preceding, the previously described coating film formed from a curable functional group-containing fluorinated polymer is preferred for the intermediate layer.

A second surface treatment layer is preferably formed at this intermediate layer on the opposite side to the water-impermeable sheet. This serves to improve the adherence between the intermediate layer and the sealant layer. This second surface treatment layer is a layer obtained by the execution of a surface treatment on the intermediate layer. This surface treatment can be exemplified by those treatments provided as examples in relation to the first surface treatment layer, whereamong corona discharge treatments and plasma discharge treatments are preferred.

In a preferred embodiment of the present invention, a coating film formed from a curable functional group-containing fluorinated polymer is formed in the solar cell module of the present invention between the water-impermeable sheet and the sealant layer and the second surface treatment layer is formed at least on the sealant layer side of this coating film.

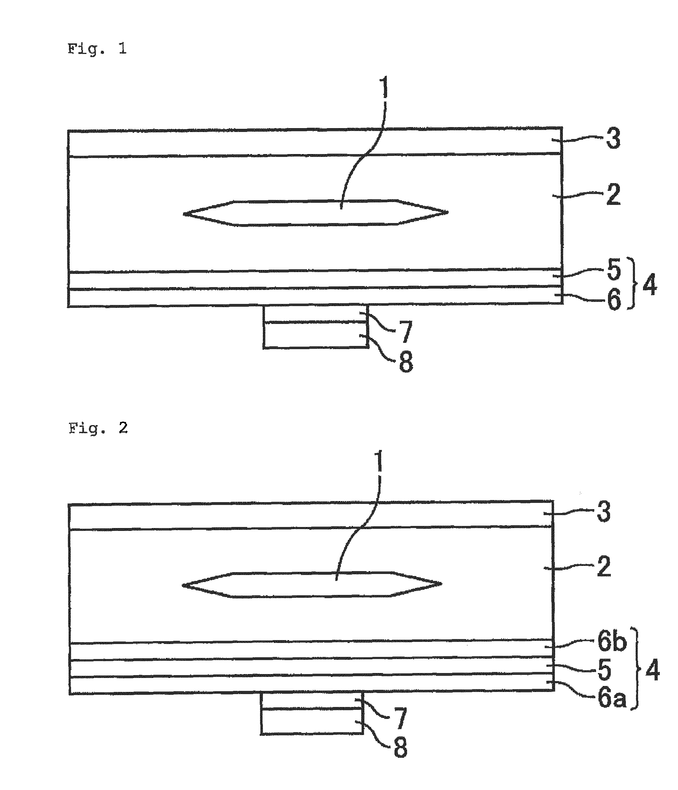

Examples of preferred structures for the solar cell module are given in Figs. 1 to 3.

In a first structure, shown in Fig. 1, a solar cell 1 is sealed in a sealant layer 2 and this sealant layer 2 is sandwiched by a surface layer 3 and a backsheet 4. The backsheet 4 is additionally constituted of a water-impermeable sheet 5 and a cured coating film 6 obtained from the coating material according to the present invention. A surface treatment that provides a wetting index of at least 40 dyn/cm is executed on the surface on the opposite side of the water-impermeable sheet 5 to the sealant layer 2. A junction box 8 is bonded, through the intermediary of an adhesion layer 7, on this surface treatment layer.

The sealant layer 2 is constituted of, for example, an ethylene/vinyl acetate copolymer (EVA), polyvinyl butyral (PVB), silicone resin, epoxy resin, acrylic resin, and so forth.

A glass plate is typically used for the surface layer 3, but a flexible material, e.g., a plastic sheet, may also be used.

In the second structure, shown in Fig. 2, the backsheet 4 has a three-layer structure in which the cured coating film 6 (cured coating films 6a and 6b) is formed on both sides of the water-impermeable sheet 5. Between the cured coating films 6 on the two sides of the water-impermeable sheet 5, a surface treatment has been executed on the cured coating film 6a on the adhesion layer 7 side to impart a wetting index of at least 40 dyn/cm to the surface in contact with the adhesion layer 7. In addition, in order to further improve the adherence with the sealant layer 2, a surface treatment may be executed, on the cured coating film 6b on the sealant layer 2 side, on the surface that will contact the sealant layer 2; however, this surface treatment may also not be performed.

This second structure, while having an increased film thickness for the backsheet, combines the advantages both of the adherence provided by the cured coating film 6b on the sealant layer 2 side and the weathering resistance (ability to prevent the infiltration of water) provided by the cured coating film 6a on the junction box 8 side.

The three-layer backsheet may also be a backsheet having a three-layer structure in which a cured coating film obtained from the coating material according to the present invention is formed on one side of the water-impermeable sheet and on the other side there is formed an adhesive layer formed from an adhesive, a cured coating film from a curable functional group-free fluorinated polymer, or a fluorinated polymer sheet, or a polyester sheet, or a polyester coating material-derived coating film (other sheet or coating film).

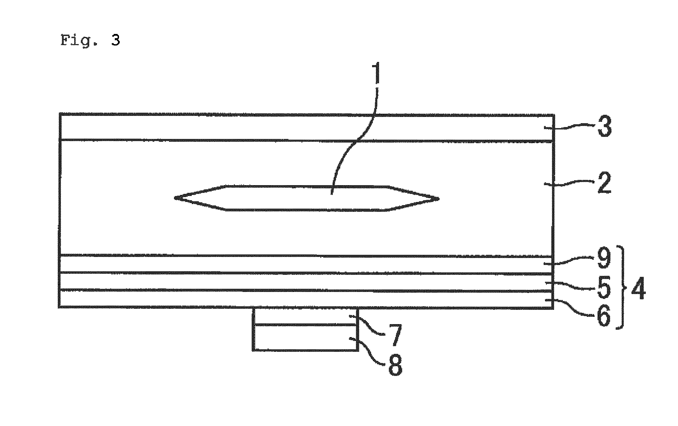

In the third structure, shown in Fig. 3, the backsheet 4 has a structure in which a cured coating film 6 obtained from the coating material for the present invention is formed on the junction box 8 side of the water-impermeable sheet 5 and an other material layer 9 is formed on the sealant layer 2 side.

The material constituting this other material layer 9 may be an adhesive, e.g., a urethane adhesive and so forth, or may be a cured coating film from a curable functional group-free fluorinated polymer coating material, or may be a fluorinated polymer sheet, or may be a polyester sheet, or may be a coating film from a polyester coating material.

A surface treatment may be executed on this other material layer 9 on the surface in contact with the sealant layer 2 in order to further improve the adhesiveness with the sealant layer 2, or such a surface treatment may be absent.

The cured coating film from a curable functional group-free fluorinated polymer coating material can be exemplified by a cured coating film from a coating material provided by the incorporation of a tetraalkoxysilane or partial hydrolyzate thereof into PVdF, as described in JP-A 2004-214342; a cured coating film from a mixed coating material of VdF/TFE/CTFE copolymer and an alkoxysilane unit-containing acrylic resin; a cured coating film from a mixed coating material of VdF/TFE/HFP copolymer and a hydroxyl group-containing acrylic resin; and a cured coating film from a coating material provided by the incorporation of an aminosilane coupling agent into a VdF/HFP copolymer. A film thickness here generally of 5 to 300 µm is preferred from the standpoint of obtaining an excellent hiding power, weathering resistance, chemical resistance, and moisture resistance. 10 to 100 µm is more preferred and 10 to 50 µm is even more preferred. An interposed primer layer and so forth may also be present in these cases.

The previously mentioned fluorinated polymer sheet can be, for example, a fluorinated polymer sheet as used in existing backsheets, e.g., a PVdF sheet or PVF sheet, a PCTFE sheet, a TFE/HFP/ethylene copolymer sheet, a TFE/HFP copolymer (FEP) sheet, a TFE/PAVE copolymer (PFA) sheet, an ethylene/TFE copolymer (ETFE) sheet, or an ethylene/CTFE copolymer (ECTFE) sheet. A film thickness here generally of 5 to 300 µm is preferred from the standpoint of obtaining an excellent weathering resistance. 10 to 100 µm is more preferred and 10 to 50 µm is even more preferred.

A polyester sheet as used in conventional backsheets can be used without modification as the polyester sheet referenced above, and its adhesion to the water-impermeable sheet 5 can be carried out with, for example, an acrylic adhesive, a urethane adhesive, an epoxy adhesive, or a polyester adhesive. A film thickness generally of 5 to 300 µm is preferred from the standpoint of obtaining an excellent weathering resistance, an excellent cost performance, and an excellent transparency. The film thickness is more preferably 10 to 200 µm, and still more preferably 10 to 100 µm.

The polyester coating material referenced above can be exemplified by polyester coating materials that use a saturated polyester resin that uses a polybasic carboxylic acid and a polyhydric alcohol and by polyester coating materials that use an unsaturated polyester resin that uses a glycol and maleic anhydride, fumaric acid, and so forth. The coating film can be formed by a coating method such as roll coating, curtain coating, spray coating, and die coating. A film thickness here of 5 to 300 µm is preferred from the standpoint of obtaining an excellent hiding power, weathering resistance, chemical resistance, and moisture resistance. 10 to 100 µm is more preferred and 10 to 50 µm is even more preferred. An interposed primer layer and so forth may also be present in this case.

### - Advantageous Effects of Invention

The solar cell module backsheet of the present invention, because it comprises the structure described in the preceding, can prevent the infiltration of water from the adhesion region with the junction box.

### BRIEF DESCRIPTION OF DRAWINGS

Fig. 1 is a schematic cross-sectional diagram of a first structure of a solar cell module;
Fig. 2 is a schematic cross-sectional diagram of a second structure of a solar cell module; and
Fig. 3 is a schematic cross-sectional diagram of a third structure of a solar cell module.

### DESCRIPTION OF EMBODIMENTS

The present invention is described in additional detail through examples, but the present invention is not limited to or by these examples.

### Preparation Example 1

202 mass parts of a curable TFE-based copolymer (Zeffle GK570 from Daikin Industries, Ltd., solids fraction = 65 mass%, hydroxyl value = 60 mg KOH/g, solvent: butyl acetate), 263 mass parts titanium oxide (D918 from Sakai Chemical Industry Co., Ltd.) as a white pigment, and 167 mass parts butyl acetate were preliminarily mixed by stirring; this was followed by the introduction of 632 mass parts glass beads having a diameter of 1.2 mm and dispersion for 1 hour at 1500 rpm in a pigment disperser. The glass beads were then filtered off using a #80 mesh sieve, and 283 mass parts of a curable TFE-based copolymer (Zeffle GK570) and 85 mass parts butyl acetate were added to the resulting solution to prepare a white dispersion material.

100 mass parts of this white dispersion 1 and 7 mass parts of a curing agent (Sumidur N3300, Sumika Bayer Urethane Co., Ltd., corresponds to 1.0 equivalent per 1 equivalent of the curable functional groups in the curable TFE-based copolymer) were blended to prepare a coating material 1.

### Production Example 1

A PET film (Lumirror S10, from Toray Industries, Inc., thickness = 250 µm, sheet A) was used as the water-impermeable sheet; the coating material 1 prepared in Preparation Example 1 was coated on one side of this sheet A using a coater to provide a dry film thickness of 10 µm; and drying was carried out for 2 minutes at 120°C. The other side was also similarly coated and dried to produce a backsheet A1 having a three-layer structure.

The surface on the junction box side of the thusly produced backsheet A1 (the surface that will be bonded in the step described below with the junction box across an interposed adhesion layer) was subjected to treatment with a corona discharge treatment device at a line speed of 100 m/minute and a discharge intensity of 1 kW to produce a surface-treated backsheet B1. The wetting index of this corona discharge-treated surface was 46 dyn/cm.

### Production Example 2

The surface on the junction box side of the backsheet A1 produced in Production Example 1 (the surface that will be bonded with the junction box across the interposed adhesion layer in the step described below) was subjected to treatment with a corona discharge treatment device at a line speed of 150 m/minute and a discharge intensity of 1 kW to produce a surface-treated backsheet C1. The wetting index of this corona discharge-treated surface was 38 dyn/cm.

### Production Example 3

The surface on the junction box side of the backsheet A1 produced in Production Example 1 (the surface that will be bonded with the junction box across the interposed adhesion layer in the step described below) was subjected to treatment with a corona discharge treatment device at a line speed of 200 m/minute and a discharge intensity of 1 kW to produce a surface-treated backsheet D1. The wetting index of this corona discharge-treated surface was 34 dyn/cm.

### Example 1

### (Production of a backsheet/silicone laminate)

The surface-treated backsheet B1 produced in Production Example 1 was cut into a circle with a diameter of 50 mm and a 2 mm × 15 mm cut was introduced at the center. A 4 mm × 30 mm section was sealed with a silicone sealant (Silicone RTV SE9185WHITE from Dow Corning Toray Co., Ltd.) so as to cover the cut region on the surface-treated side followed by standing for 2 days at room temperature to produce a backsheet/silicone laminate B2.

### Comparative Example 1

The surface-treated backsheet C1 produced in Production Example 2 was cut into a circle with a diameter of 50 mm and a 2 mm × 15 mm cut was introduced at the center. A 4 mm × 30 mm section was sealed with a silicone sealant (Silicone RTV SE9185WHITE from Dow Corning Toray Co., Ltd.) so as to cover the cut region on the surface-treated side followed by standing for 2 days at room temperature to produce a backsheet/silicone laminate C2.

### Comparative Example 2

The surface-treated backsheet D1 produced in Production Example 3 was cut into a circle with a diameter of 50 mm and a 2 mm × 15 mm cut was introduced at the center. A 4 mm × 30 mm section was sealed with a silicone sealant (Silicone RTV SE9185WHITE from Dow Corning Toray Co., Ltd.) so as to cover the cut region on the surface-treated side followed by standing for 2 days at room temperature to produce a backsheet/silicone laminate D2.

### Comparative Example 3

The backsheet A1 produced in Production Example 1 was cut into a circle with a diameter of 50 mm and a 2 mm × 15 mm cut was introduced at the center. A 4 mm × 30 mm section was sealed with a silicone sealant (Silicone RTV SE9185WHITE from Dow Corning Toray Co., Ltd.) so as to cover the cut region on one side of the backsheet A1 followed by standing for 2 days at room temperature to produce a backsheet/silicone laminate A2.

The test and measurement methods are described below.

### (The film thickness)

This was measured using a micrometer (Mitutoyo Corporation) based on JIS C 2151.

### (The water infiltration test)

10 g of pure water was introduced into a metal cup having a diameter of 50 mm and a depth of 20 mm; the backsheet/silicone laminate obtained in the example or comparative example was mounted on the cup with the silicone side facing the pure water; and packing and a lid (mesh with a diameter of 30 mm at the center) were fastened thereon with screws. The thusly produced sample was turned to place the lid down and was held for 3 days in a 40°C oven, after which the reduction in weight was measured.

A weight reduction measured by this method of less than 0.1 g was scored with a "○", while a weight reduction of 0.1 g or more was scored with an "×". The results are given in Table 1.

**[Table 1]**

| | Wetting index (dyn/cm) | Water infiltration (40°C, 3 days) |
|---|---|---|
| Example 1 | 46 | ○ |
| Comparative Example 1 | 38 | × |
| Comparative Example 2 | 34 | × |
| Comparative Example 3 | Not treated | × |

### Example 2

### (Production of a solar cell module)

A solar cell module with the structure shown in Fig. 2 was produced using a tempered glass sheet (18 cm square) as the surface layer 3, using a resin sheet (18 cm square) from an ethylene-vinyl acetate copolymer (EVA) as the sealant layer 2, using a polycrystalline silicon solar cell (15 cm square) as the solar cell 1, and using, as the backsheet 4, the surface-treated backsheet B1 (18 cm square) produced in Production Example 1, which in this case had also been subjected to a corona treatment on the EVA side (side that will come into contact with the EVA layer when lamination is performed). These were stacked in the sequence shown in Fig. 2 and, using a vacuum laminator (NPC Incorporated), were laminated at 135°C under a vacuum draw for 5 minutes and pressure increase to atmospheric pressure for 15 minutes to produce a solar cell module laminate. During the production of this solar cell module laminate, the wiring to the solar cell was run out in advance through regions where cuts had been introduced in the EVA and backsheet.

The edge faces of the thusly produced solar cell module laminate were then sealed with a frame (aluminum) and bonding and sealing were performed by casting a silicone sealant (Silicone RTV SE9185WHITE, Dow Corning Toray Co., Ltd.) into the gaps between the frame and the solar cell module laminate.

In addition, the wiring run out from the cut region in the backsheet was connected to a junction box and bonding and sealing were performed by casting a silicone sealant (Silicone RTV SE9185 WHITE from Dow Corning Toray Co., Ltd.) into the interface between the junction box and the backsheet.

Finally, curing was carried for 1 week at room temperature to produce a solar cell module.

### REFERENCE SIGNS LIST

- 1:: solar cell
- 2:: sealant layer
- 3:: surface layer
- 4:: backsheet
- 5:: water-impermeable sheet
- 6:: cured coating film
- 7:: adhesion layer
- 8:: junction box
- 9:: other material layer

## Claims

1. A backsheet for a solar cell module, having a water-impermeable sheet and a coating film formed on at least one side of the water-impermeable sheet, wherein
the coating film is formed from a coating material containing a curable functional group-containing fluorinated polymer,
a first surface treatment layer is formed on the coating film at least on a surface on an opposite side to the water-impermeable sheet, and
the wetting index of the first surface treatment layer is at least 40 dyn/cm.

2. The backsheet for a solar cell module according to claim 1, wherein the first surface treatment layer is obtained by a corona discharge treatment and/or a plasma discharge treatment.

3. The backsheet for a solar cell module according to claim 1 or claim 2, wherein the curable functional group-containing fluorinated polymer comprises a polymerization unit based on a fluorine-containing monomer and a polymerization unit based on at least one curable functional group-containing monomer selected from the group consisting of hydroxyl group-containing monomers, carboxyl group-containing monomers, acid anhydride monomers, amino group-containing monomers, and silicone-based vinyl monomers.

4. The backsheet for a solar cell module according to claim 3, wherein the fluorine-containing monomer is at least one selected from the group consisting of tetrafluoroethylene, chlorotrifluoroethylene, and vinylidene fluoride.

5. The backsheet for a solar cell module according to claim 1, 2, 3, or 4, wherein the coating material comprises at least one compound selected from the group consisting of polyisocyanate compounds derived from at least one isocyanate selected from the group consisting of xylylene diisocyanate and bis(isocyanatomethyl)cyclohexane, blocked isocyanate compounds based on hexamethylene diisocyanate, polyisocyanate compounds derived from hexamethylene diisocyanate, and polyisocyanate compounds derived from isophorone diisocyanate.

6. A laminate comprising the backsheet according to claim 1, 2, 3, 4, or 5, an adhesion layer, and a junction box, wherein
the adhesion layer is disposed on the first surface treatment layer of the backsheet; and
the junction box is disposed on a surface on an opposite side of the adhesion layer to the backsheet.

7. The laminate according to claim 6, wherein the adhesion layer comprises at least one selection from the group consisting of silicone resins, acrylic resins, and urethane resins.

8. A solar cell module that has the laminate according to claim 6 or 7 and a sealant layer that seals a solar cell and is disposed on the opposite side of the backsheet to the junction box.

9. The solar cell module according to claim 8, wherein a coating film formed from a coating material containing a curable functional group-containing fluorinated polymer is formed between the water-impermeable sheet and the sealant layer, and a second surface treatment layer is formed on at least the sealant layer side of this coating film.

10. The solar cell module according to claim 9, wherein the second surface treatment layer is obtained by a corona discharge treatment and/or a plasma discharge treatment.
